# EUROPEAN PATENT APPLICATION

(11) **EP 0 599 463 A2**
(43) Date of publication of application: **01.06.1994**
(21) Application number: 93307793.5
(22) Date of filing: 30.09.1993
(51) Int. Cl.: G03F 7/095

(54) **High speed, dry processed printing plate construction**

(30) Priority: 17.11.1992 US 977810
(71) Applicant: MINNESOTA MINING AND MANUFACTURING COMPANY, St. Paul, Minnesota 55133-3427 (US)
(72) Inventor: Busman, Stanley C., c/o Minnesota Mining and, St. Paul, Minnesota 55133-3427 (US); Chang, Jeffrey C., c/o Minnesota Mining and, St. Paul, Minnesota 55133-3427 (US); Simmonsen, Kimberly A., c/o Minnesota Mining and, St. Paul, Minnesota 55133-3427 (US); Shor, Steven M., c/o Minnesota Mining and, St. Paul, Minnesota 55133-3427 (US); Vogel, Dennis E., c/o Minnesota Mining and, St. Paul, Minnesota 55133-3427 (US); Winslow, John M., c/o Minnesota Mining and, St. Paul, Minnesota 55133-3427 (US)
(74) Representative: Bowman, Paul Alan

(57) **Abstract**

High speed, dry processed, multilayer lithographic printing plate constructions comprise a substrate, a light-sensitive layer comprising a polymer derived from an acid labile ester and a photoacid progenitor, and a dry silver layer comprising a light-sensitive silver source, a light-insensitive reducible silver source, a binder, and a reducing agent.

## Description

This invention relates to lithographic printing plate constructions. More particularly, the invention relates to high speed, dry processed lithographic printing plate constructions.

The use of silver halide emulsion layers as integral topcoat masks for flood exposure of an underlying light-sensitive photopolymer layer is known in the art as disclosed in U.S. Patent Nos. 3,245,793, 3,511,611, 3,730,717, 4,254,210, 4,268,609, 4,299,912, 4,478,930, 4,977,076; European Patent Application 118,096, and Japanese published patent applications 60-61752, 2-54270, 2-23356. The flood exposure step is followed by either wet substrate etching, peel apart development, or toning the tacky polymer to give positive or negative images. However, the above-cited references require wet processing to develop the silver halide image, and in some cases a wet development step is required to wash away material from the light-sensitive photopolymer layer.

U.S. Patent No. 4,666,818 discloses the use of dry silver integral topcoat masks for conventional photopolymers, and describes printed circuit manufacture. Stripping the silver mask and a wet development step are required to wash away material from the light-sensitive photopolymer layer.

Japanese published patent application 55-50246 discloses a photothermographic silver-containing photopolymer construction consisting of an aluminum substrate sequentially coated thereon with an acrylate-based photopolymer layer, a transparent interlayer, and a dry silver layer. After exposure and development of the photothermographic silver-containing layer, and subsequent UV flood exposure, the construction is peeled apart, and the unexposed areas are carried away with transparent layer and photothermographic silver containing layer, leaving the exposed photopolymer areas on the aluminum substrate. Peel-apart development generally gives poor resolution for printing plate applications.

European published patent applications 360,014 and 363,790 disclose the combination of photopolymer and dry silver chemistries in a single layer. In those cases the dry silver image formed within the photopolymer layer after exposure and heat development serves as a mask during a subsequent blanket UV exposure step. Alternatively, the dry silver layer may be separate from the photopolymer layer. In either case the blanket exposed photopolymer layer is wet developed with organic solvents to remove unpolymerized regions of the plate.

Japanese published patent application 59-222,841 discloses the use of an integral strippable dry silver topcoat mask for driographic silicone printing plates. The flood exposed printing plate is wet processed after removal of the dry silver layer.

Japanese published patent application 3-287,258 discloses the use of an integral strippable dry silver topcoat mask for photosensitive layers that change from hydrophobic to hydrophilic or from hydrophilic to hydrophobic without the need for wet development.

The present invention relates to high speed, dry-processed lithographic printing plates comprising a substrate, a thermographic imaging layer or a photothermographic imaging layer, and a light-sensitive photopolymer layer comprising a polymer derived from an acid labile ester and a photoacid progenitor.

In one aspect, the present invention relates to high speed, dry-processed lithographic printing plate constructions in which a substrate is sequentially coated on the same side with a light-sensitive photopolymer layer comprising a polymer derived from an acid labile ester and a photoacid progenitor, a strippable interlayer, and a photothermographic imaging layer.

In another aspect, the present invention relates to high speed, dry-processed lithographic printing plate constructions in which a substrate is sequentially coated on the same side with a light-sensitive photopolymer layer comprising a polymer derived from an acid labile ester and a photoacid progenitor, a strippable interlayer, a dry developable photothermographic imaging layer or thermographic imaging layer, and a barrier layer.

In yet another aspect, the invention relates to high speed, dry-processed lithographic printing plate constructions in which a transparent substrate is sequentially coated on the same side with a dry developable thermographic imaging layer or a dry developable photothermographic imaging layer, an interlayer, and a light-sensitive photopolymer layer comprising a polymer derived from an acid labile ester and a photoacid progenitor.

In a further aspect, the invention relates to a high speed, dry-processed lithographic printing plate construction in which a transparent substrate is coated on opposite sides with a thermographic or photothermographic imaging layer and a light-sensitive photopolymer layer comprising a polymer derived from an acid labile ester and a photoacid progenitor.

In a still further aspect, the invention relates to a high speed, dry-processed lithographic printing plate construction in which a transparent substrate is coated on one side with a thermographic or photothermographic imaging layer having a protective barrier layer coated thereon and on the other side of the substrate is coated a light-sensitive photopolymer layer comprising a polymer derived from an acid labile ester and a photoacid progenitor.

The high speed printing plate system of the present invention may have a number of physical constructions. Among the constructions contemplated in the practice of the present invention are, for example: 1) a plate comprising a substrate (opaque or transparent), a photopolymer layer, a strippable interlayer, the thermographic or photothermographic imaging layer(s), and an optional barrier layer, 2) a plate comprising a transparent substrate, a thermographic imaging layer or a photothermographic imaging layer(s), an interlayer, and a photopolymer layer, and 3) a printing plate comprising a photopolymer layer, a transparent substrate, a thermographic imaging layer or a photothermographic imaging layer, having thereon an optional barrier topcoat. Other layers as mentioned herein may be present, and, as well known in the art, the photothermographic imaging layer(s) or, alternatively, the thermographic imaging layer(s) may be a single layer or two adjacent layers acting in concert.

In the two layer photothermographic "layer" or system, as is well understood in the art, the light sensitive silver forming material (the silver halide) and the image silver source (e.g., the silver salt of an organic acid) are present in a single layer. The other essential or auxiliary ingredients may be distributed amongst the two layers in the photothermographic "layer".

The bonded structure contemplated in the practice of the present invention is a substrate, a photopolymer printing plate layer, and a photothermographic imaging layer, with the proviso that if the photopolymer layer is between the substrate and the photothermographic layer, the photothermographic layer must be strippable from the photopolymer layer in the structure. The photopolymer layer is, of course, left on the substrate in this stripping operation.

The term "dry silver" or "photothermographic imaging" as used herein refers to photothermographic compositions (in one or two layers) comprising an intimate mixture of a light-sensitive silver halide, a substantially light-insensitive silver compound such as a silver salt of an organic acid (e.g., silver behenate or silver saccharine) which upon reduction gives a visible change, a binder and a reducing agent. Dry silver mixtures are usually prepared in a solvent as a dispersion and spread as a layer on a suitable substrate. When dry, the layer (or adjacent layers containing a distribution of those essential ingredients) is exposed to a light image and thereafter a reproduction of the image is developed by heating the coated substrate. Examples of dry silver imaging constructions are given in U.S. Patent Nos. 3,994,732, 4,123,282, 4,585,734, and 4,587,211 which are incorporated herein by reference. It is to be noted that in the practice of the present invention where a photothermographic imaging layer is described, the term includes the use of two separate but adjacent layers which contain all of the ingredients necessary for the layer(s) to form a photothermographic image.

Silver halides known in the art for use in dry silver are useful in the present invention and include, but are not limited to, silver chloride, silver chlorobromide, silver chloroiodide, silver bromide, silver iodobromide, silver chloroiodobromide, and silver iodide. The silver halides may be formed *in situ*, or may be preformed and added to the emulsion as disclosed in U.S. Patent No. 4,161,408. T-grain and core-shell silver halide emulsions may be used in the practice of the invention.

The silver halide used in the present invention may be unmodified. However, it may also be chemically sensitized with a chemical sensitizing agent such as compounds of sulfur, selenium or tellurium, etc., or compounds of gold, platinum, palladium, rhodium or iridium, etc., a reducing agent such as tin halide, etc., or a combination thereof. Details of such additions are described in James, T.H., *The Theory of the Photographic Process*, Fourth Ed.; MacMillan: New York, 1977; pp 149-169.

The silver halide used in the present invention can be spectrally sensitized with spectral sensitizing dyes such as methine dyes or other dyes. Suitable dyes that can be employed include cyanine dyes, merocyanine dyes, complex cyanine dyes, complex merocyanine dyes, holopolar cyanine dyes, hemicyanine dyes, styryl dyes, and hemioxonol dyes. Of these dyes, cyanine dyes, merocyanine dyes and complex merocyanine dyes are particularly useful.

The light-sensitive silver halide used in the present invention can be employed in a range of 0.005 mole to 0.5 mole and, preferably, from 0.01 mole to 0.15 mole per mole of organic silver salt.

Substantially light-insensitive organic silver salts that may be used in the present invention are silver salts that are comparatively stable to light, and which form a silver image when reduced by reducing agent when they are heated to a temperature of above 80°C, and, preferably, above 100°C in the presence of exposed silver halide (or silver). Suitable organic silver salts include silver salts of organic compounds having a carboxy group. Preferred examples thereof include silver salts of aliphatic and aromatic carboxylic acids. Preferred examples of silver salts of aliphatic carboxylic acids include silver behenate, silver stearate, silver oleate, silver laurate, silver caproate, silver myristate, silver palmitate, silver maleate, silver fumarate, silver tartarate, silver furoate, silver linoleate, silver butyrate and silver camphorate, mixtures thereof, etc. Silver salts that are substituted with a halogen atom or a hydroxyl group can also be effectively used. Preferred examples of silver salts of aromatic carboxylic acids and other carboxyl group-containing compounds include silver benzoate, silver substituted benzoates such as silver 3,5-dihydroxybenzoate, silver *o*-methylbenzoate, silver *m*-methylbenzoate, silver *p*-methylbenzoate, silver 2,4-dichlorobenzoate, silver acetamidobenzoate, silver *p*-phenyl benzoate, etc.; silver gallate, silver tannate, silver phthalate, silver terephthalate, silver salicylate, silver phenylacetate, silver pyromellitate, silver salts of 3-carboxymethyl-4-methyl-4-thiazoline-2-thiones or the like as described in U.S. Patent No. 3,785,830; and silver salts of aliphatic carboxylic acids containing a thioether group as described in U.S. Patent No. 3,330,663, etc. Silver salts of compounds containing mercapto or thione groups and derivatives thereof can also be used. Preferred examples of these compounds include silver 3-mercapto-4-phenyl-1,2,4-triazolate, silver 2-mercaptobenzimidazolate, and silver 2-mercapto-5-aminothiadiazolate; silver 2-(*S*-ethylglycolamido)benzothiazolate; silver salts of thioglycolic acids such as silver salts of *S*-alkyl thioglycolic acids (wherein the alkyl group has from 12 to 22 carbon atoms), silver salts of dithiocarboxylic acids such as silver dithioacetate, silver thioamidoate, silver 1-methyl-2-phenyl-4-thiopyridine-5-carboxylate, silver triazinethiolate, silver 2-sulfidobenzoxazole; silver salts as described in U.S. Patent No. 4,123,274. Furthermore, silver salts of a compound containing an amino group can be used. Preferred examples of these compounds include silver salts of benzotriazoles, such as silver benzotriazolate; silver salts of alkynes such as silver 1-butyn-1-ide, silver propyn-1-ide, and the like; silver salts of arylalkynes such a silver phenylacetylide and substituted derivatives; silver salts of alkyl substituted benzotriazoles such as silver methylbenzotriazolate, etc.; silver salts of halogen substituted benzotriazoles such as silver 5-chlorobenzotriazolate; silver salts of carboimidobenzotriazoles; silver salts of 1,2,4-triazoles and 1-*H*-tetrazoles as described in U.S. Patent No. 4,220,709; silver salts of imidazoles; and the like.

A wide range of reducing agents are known in the art to be useful in photothermography including, but not limited to, amidoximes such as phenylamidoxime, 2-thienylamidoxime and *p*-phenoxyphenylamidoxime; azines, for example 4-hydroxy-3,3-dimethoxybenzaldehyde azine; a combination of aliphatic carboxylic acid aryl hydrazides and ascorbic acid, such as 2,2-bis(hydroxymethyl)propionyl-β-phenylhydrazide in combination with ascorbic acid; a combination of polyhydroxybenzene and hydroxylamine; a reductone and/or a hydrazine, for example a combination of hydrequinone and bis(ethoxyethyl)hydroxylamine, piperidinohexose reductone or formyl-4-methylphenylhydrazine; hydroxamic acids such as phenylhydroxamic acid, *p*-hydroxyphenylhydroxamic acid, and β-alaninehydroxamic acid; a combination of azines and sulfonamidophenols, for example phenothiazine and 2,6-dichloro-4-benzenesulfonamidophenol; α-cyanophenylacetic acid derivatives such as ethyl α-cyano-2-methylphenylacetate, ethyl α-cyanophenylacetate; bis-β-naphthols as illustrated by 2,2-dihydroxy-1,1-binaphthyl, 6,6-dibromo-2,2-dihydroxy-1,1-binaphthyl, and bis(2-hydroxy-1-naphthyl)methane; a combination of bis-β-naphthol and a 1,3-dihydroxybenzene derivative, for example 2,4-dihydroxybenzophenone or 2,4-dihydroxyacetophenone; 5-pyrazolones such as 3-methyl-1-phenyl-5-pyrazolone; reductones as illustrated by dimethylaminohexose reductone, anhydrodihydroaminohexose reductone, and anhydrodihydropiperidinohexose reductone; sulfonamidophenol reducing agents such as 2,6-dichloro-4-benzenesulfonamidophenol, and *p*-benzenesulfonamidophenol; 2-phenylindane-1,3-dione and the like; chromans such as 2,2-dimethyl-7-*t*-butyl-6-hydroxychroman; 1,4-dihydropyridines such as 2,6-dimethoxy-3,5-dicarboethoxy-1,4-dihydropyridine; bisphenols, for example bis(2-hydroxy-3-*t*-butyl-5-methylphenyl)methane, 2,2-bis(4-hydroxy-3-methylphenyl)propane, bis(3,5-di-*t*-butyl-4-hydroxyphenyl)methane, 4,4-ethylidene-bis(2-*t*-butyl-6-methylphenol), and 2,2-bis(3,5-dimethyl-4-hydroxyphenyl)propane; ascorbic acid derivatives, for example 1-ascorbyl palmitate, 1-ascorbyl stearate and unsaturated aldehydes and ketones such as benzil and diacetyl; 3-pyrazolidones and certain indane-1,3-diones. Additionally, the reducing agent may be an oxidizable leuco dye as described, for example, in U.S. Patent No. 4,594,307.

The silver halide and the organic silver salt that form a starting point of development should be in reactive association (i.e., in catalytic proximity or in the same layer), or in adjacent layers. It is preferred that the silver halide and the organic silver salt are present in the same layer.

The silver halide and the organic silver salt, which may be separately or simultaneously formed in a binder, may be mixed before use to prepare a coating solution, but it is also effective to blend both of them in a ball mill for a long time. Frequently it is advantageous to homogenize the silver halide and organic silver salt under pressures ranging from 2.8 x 10⁸ to 5.6 x 10⁸ Pascals (i.e., 4,000 to 8,000 psi). Further, it is effective to use a process that comprises adding a halogen-containing compound in the organic silver salt prepared to partially convert the silver of the organic silver salt to silver halide. Methods of preparing silver halide and organic silver salts and manners of blending them are described in *Research Disclosures* No. 17029 and U.S. Patent No. 3,700,458.

A suitable coating amount of the light-sensitive silver halide and the organic silver salt employed in the present invention is in a total amount ranging from 50 mg to 10 g/m² calculated as an amount of silver as disclosed, for example, in U.S. Patent No. 4,478,927.

The light-sensitive silver halide and the organic silver salt oxidizing agent used in the present invention are combined with the reducing agent and added to a binder as described below. The binder(s) that can be used in the present invention can be employed individually or as a combination thereof. The binder may be hydrophilic or hydrophobic. A typical hydrophilic binder is a transparent or translucent hydrophilic colloid, examples of which include natural substances, for example, proteins such as gelatin and gelatin derivatives, cellulose derivatives, etc., polysaccharides such as starch, gum arabic, pullulan, dextrin, etc., and synthetic polymers such as, for example, water-soluble polyvinyl compounds such as polyvinyl alcohol, polyvinyl pyrrolidone, acrylamide polymer, etc. Another example of a hydrophilic binder is a dispersed vinyl compound in latex form which is used for the purpose of increasing dimensional stability of a photographic material.

The coating amount of the binder used in the present invention is generally 20 g or less per m², preferably 10 g or less per m², and more preferably 7 g or less per m².

The preferred dry silver containing polymer is polyvinyl butyral, but ethyl cellulose, methacrylate copolymers, maleic anhydride ester copolymers, polystyrene, and butadiene-styrene copolymers, can be used where applicable according to the solvents used.

The photothermographic imaging layer of the present invention may contain inorganic or organic hardeners. It is possible to use chromium salts such as chromium alum, chromium acetate, etc.; aldehydes such as formaldehyde, glyoxal, glutaraldehyde, etc.; *N*-methylol compounds such as dimethylolurea, methylol dimethylhydantoin, etc.; dioxane derivatives such as 2,3-dihydroxydioxane, etc.; active vinyl compounds such as 1,3,5-triacryloylhexahydro-*s*-triazine, 1,3-vinylsulfonyl-2-propanol, etc.; active halogen compounds such as 2,4-dichloro-6-hydroxy-*s*-triazine, etc.; mucohalogenic acids such as mucochloric acid, mucophenoxychloric acid, etc.; isocyanate cross-linking agents such as hexanediisocyanate, 1,3,5-triisocyanatobenzene, and so on; which may be used individually or as a combination thereof.

Substrates that are useful in practice of the present invention include rigid and flexible substrates; metals (for example steel and aluminum plates, sheets, and foils); films or plates composed of various film-forming synthetic or high polymers including addition polymers (for example polyvinylidene chloride, polyvinyl chloride, polyvinyl acetate, polystyrene, polyisobutylene polymers and copolymers), and linear condensation polymers (for example polyethylene terephthalate, polyhexamethylene adipate, polyhexamethylene adipamide/adipate); nonwoven wood byproduct based substrates such as paper and cardboard; and glass. Substrates may be transparent or opaque, although in the case of coating constructions where backside irradiation (exposure) is to be performed, a transparent substrate must be used. Useful substrates include, but are not limited to, films of cellulose acetate films such as cellulose triacetate or diacetate; films of polyamides derived from a combination of heptamethylenediamine and terephthalic acid, a combination of fluorenedipropylamine and adipic acid, a combination of hexamethylenediamine and diphenic acid, and a combination of hexamethylenediamine and isophthalic acid; films of polyesters derived from a combination of diethylene glycol and diphenylcarboxylic acid and a combination of bis-*p*-carboxyphenoxybutane and ethylene glycol, a polyethylene terephthalate (PET) film, and a polycarbonate film. Said films may be modified. For example, polyethylene terephthalate films may be modified by such modifiers as cyclohexanedimethanol, isophthalic acid, methoxypolyethylene glycol or 1,2-dicarbomethoxybenzenesulfonic acid. Primer layers or subbing layers may be used. The substrate used in the present invention should be one that has good dimensional stability at the processing temperature. Aluminum and polyethylene terephthalate films are preferred substrates, with or without special coatings or surface treatments (such as anodizing or graining) thereon.

The dry silver layer may contain surface active agents for various purposes, for example, as primers for the substrate, as coating aids or for prevention of electrical charging, improvement of lubricating properties, emulsification, prevention of adhesion, improvement of photographic properties (for example, acceleration of development providing hard tones or sensitization), etc. For example, it is possible to use nonionic surface active agents such as saponin (steroid), alkylene oxide derivatives (for example, polyethylene glycol/polypropylene glycol condensates, polyethylene glycol alkyl ethers or polyethylene glycol alkylaryl ethers, polyethylene glycol esters, polyethylene glycol sorbitan esters, polyalkylene glycol alkyl amines or amides, polyethylene oxide adducts of silicone, etc.), glycidol derivatives (for example, alkenylsuccinic acid polyglycerides, alkylphenol polyglycerides, etc.), polyhydric alcohol aliphatic acid esters or saccharide alkyl esters, etc.; anionic surface active agents containing acid groups such as a carboxyl group, a sulfo group, a phospho group, a sulfate group, a phosphate group, etc., such as alkylcarboxylic acid salts, alkylsulfonic acid salts, alkylbenzenesulfonic acid salts, alkylnaphthalenesulfonic acid salts, alkyl sulfuric acid esters, alkylphosphoric acid esters, *N*-acyl-*N*-alkyltaurines, sulfosuccinic acid esters, sulfoalkyl polyoxyethylene alkyl phenyl ethers, polyoxyethylene alkylphosphoric acid esters, etc.; ampholytic surface active agents such as amino acids, aminoalkylsulfonic acids, aminoalkylsulfuric acid esters or phosphoric acid esters, alkyl betaines, amine oxides, etc.; and cationic surface active agents such as alkylamine salts, aliphatic or aromatic quaternary ammonium salts, heterocyclic quaternary ammonium salts such as pyridinium salts, imidazolium salts, etc., aliphatic or heterocyclic phosphonium salts, aliphatic or heterocyclic sulfonium salts, etc.

The nonionic surface active agents capable of satisfying the above described conditions are well known as to their structures, properties and methods of synthesis. These nonionic surface active agents are widely used even outside the field of the present invention. A representative reference relating to these agents is *Nonionic Surfactants*; Schick, M.J., Ed.; Surfactant Science Series; Marcel Dekker: New York, 1967; Vol. 1. Among the nonionic surface active agents described in the above-mentioned references, those capable of satisfying the above described conditions are preferably employed in connection with the print invention. The nonionic surface active agents can be used individually or as a mixture of two or more of them.

The dry silver layer used in the present invention may have, if desired or necessary, a layer or layers other than the dry silver imaging layer, for example, an antistatic layer, an electrically conductive layer, a protective layer, an intermediate layer, an antihalation layer, etc.

In the present invention, the latent image obtained after exposure of the dry silver layer can be developed by heating the dry silver layer at a moderately elevated temperature of, for example, about 80° to about 250°C for about 0.5 second to about 300 seconds. By increasing or decreasing the heating time, the temperature may be higher or lower within the above range. Temperatures in the range of about 110° to about 160°C are especially useful. Heating may be carried out by said usual heating means such as a hot plate, an iron, infrared heating, resistive heating (as of a layer in the plate structure), a hot roller, a heat generator using carbon or titanium white, or the like.

Interlayers of the present invention may serve to prevent diffusion of components of the thermographic layer into the photopolymer layer and be strippable or non-strippable. Interlayers comprise a synthetic or natural polymeric resin. Interlayers useful in the present invention include those known in the dry silver art and described for example in U.S. Patent No. 4,460,861. Non-limiting examples of interlayer polymer resins include polyvinyl chloride and polyvinylidene chloride homopolymers and copolymers, acrylate and methacrylate homopolymers and copolymers; polyolefin polymers such as polypropylene, polyethylene, polyvinyl pyrrolidone, polystyrene, and homopolymers and copolymers of vinyl acetate including polyvinyl alcohols; condensation polymers such as polyamides, polyesters, polyurethanes; polyaldehyde polymers such as polyvinyl formal and polyvinyl butyral; carbohydrates including pullulan and cellulosic derivatives such as hydroxypropyl methyl cellulose; gelatin and its derivatives; and the like.

As the photopolymer layer of the present invention relies upon a change of surface energy following a blanket exposure, it is desirable that strippable interlayers must be essentially completely removable by peeling from the photopolymer layer. Incomplete removal of the strippable interlayer generally results in decreased resolution. Polyvinyl alcohol, gelatin, hydroxypropyl methyl cellulose, and pullulan, optionally in combination with a surfactant are preferred materials for use in strippable interlayers of the present invention.

The dry silver layers of the present invention may be overcoated with a protective barrier layer. Suitable materials for the barrier layer include, but are not limited to polymers that are insoluble in aqueous systems, soluble in some organic solvents, and impervious to certain other organic solvents. The barrier may be any synthetic or natural polymer that may be coated onto the preceding layer including methyl methacrylate polymers (preferably hard polymers with a Tukon hardness of 20 or more), copolymers, or blends with other polymers or copolymers (for example co-polymers with *n*-butyl acrylate, butyl methacrylate, and other acrylates such as acrylic acid, methacrylic acid, acrylic anhdride, and the like), polystyrene, or a combination of a polyvinyl chloride tripolymer with a butadiene-styrene copolymer.

If necessary, two or more layers may be applied at the same time by the method as described in U.S. Patent No. 2,761,791 and British Patent No. 837,095.

The light-sensitive photopolymer layer of the printing plate construction of the present invention may comprise any resist imageable or self-developing photopolymeric imaging layer known in the art. By resist imageable is meant a layer whose solubility in a particular solvent is sufficiently altered by irradiation that an image of the irradiated pattern of photopolymer will remain on the plate after exposure and development (negative acting system) or a pattern of irradiated polymer will be removed after exposure and development (positive acting system). The typical negative acting system would comprise at least a photopolymerizable component, usually with a photocatalyst (e.g., photoinitiator system). It would comprise various combinations of polymerizable polymers, oligomers and monomers, inert polymeric binders, photoinitiator systems, light sensitive dyes, light inert dyes, surfactant, sensitizing dyes, solvents, and the like. A typical positive acting system would be exemplified by a phenolic-diazo oxide imaging system.

In a preferred embodiment, light-sensitive photopolymer layers of the present invention comprise a polymer derived from an acid labile ester and a photoacid progenitor. Polymers derived from acid labile esters may be homopolymers or copolymers of at least one monomer having an acid labile ester group, including acrylate and methacrylate esters such as alkoxyalkyl esters, *t*-butoxycarbonyl esters, *t*-butyl esters, silyl esters, and the like as described in, for example, U.S. Patent No. 4,491,628 which is incorporated herein by reference.

Preferred polymers derived from acid labile esters are polymers having pendant groups of the formula: 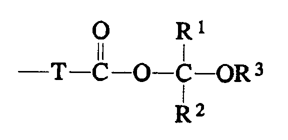
wherein **R¹** and **R²** independently represent hydrogen or an alkyl group having from 1 to 18 carbon atoms, and **R³** represents an alkyl group having from 1 to 18 carbon atoms, and further wherein any two of **R¹**, **R²**, and **R³** may together form a substituted or unsubstituted ring having from 2 to 36 carbon atoms; **T** represents a bond or a divalent linking group between the polymer backbone and the alkoxyalkyl ester moiety and has from at least 0 to about 18 carbon, nitrogen, oxygen, and sulfur atoms combined, particularly wherein **T** contains no functional groups which are more basic than the alkoxyalkyl ester employed in the present invention (i.e., such as free amines, alkoxides, sulfides, amides, urethanes, imides, etc. should be absent) Thus, **T** may constitute a C-C single bond or a chain (especially a hydrocarbon chain, aliphatic, aromatic, or mixed aliphatic-aromatic hydrocarbon chain) such as methylidene, 1,5-pentanediyl, 2-oxo-1,3-propanediyl, phenylene, and the like, preferably with at least two carbon atoms in the chains for each heteroatom.

The polymers of the present invention may be derived from any non-basic (i.e., not containing 1°, 2°, or 3° amines or phosphines) polymer backbone, and may be prepared by any of the known in the art methods for preparing polymers (such as free radical, anionic, condensation, and cationic polymerization). Non-limiting examples of non-basic polymer backbones are polyacrylates, polymethacrylates, polystyrenes, acrylonitrile-styrene copolymers, butadiene-styrene copolymers, butadiene-styrene-acrylonitrile, polyolefins (e.g., polyethylene, polypropylene, polyisobutylene, etc.), polyesters, polyethers, polycarbonates, polysulfides, and the like). Examples of basic polymer backbones are those having nitrogen in any form other than quaternary nitrogen. Preferred polymer backbones are derived from free radical polymerized polymers. Particularly preferred polymer backbones are polyacrylates and polymethacrylates. Additionally, it may be desirable in some applications that the polymer matrix be cross-linked, while in other instances it may be preferable that there be no cross-linking.

Alkoxyalkyl ester moieties may be either incorporated within monomer units prior to polymerization or attached to already formed polymer backbones using methods well known in the chemical art. For example, in cases in which active hydrogen is present on the polymer backbone (for example, when -OH, -C(O)CH₂C(O)-, -SH, and the like), deprotonation with a strong base (such as sodium hydride, lithium diisopropylamide, potassium *t*-butoxide, or any other base having sufficient strength to abstract said active hydrogen), followed by condensation with alkoxyalkyl ester moieties having reactive groups such as epoxy, haloacyl, carboxyalkyl, and the like may be used to prepared the polymers of the present invention. In cases in which olefinic unsaturation is present, alkoxyalkyl ester moieties have alkene substituents may be added by reactions such as Diels-Alder 4+2 thermal cycloadditions or 2+2 photocycloaddition. In still other cases in which no recognized functionality is present (e.g., polyethylene, polypropylene, etc.), one may corona treat or otherwise oxidize said polymer to provide active hydrogen sites on the polymer backbone.

The term photoacid progenitor as used herein refers to a substance or substances which taken individually or in combination generates a Lewis or Brønsted acid upon exposure to actinic radiation. Many such substances are known in the photoimaging art including, but not limited to, various onium compounds (e.g., sulfonium, iodonium, diazonium, etc.; particularly aryl derivatives thereof), and various organic compounds with photolabile halogen atoms (α-halo-*p*-nitrotoluenes, α-halomethyl-*s*-triazines, carbon tetrabromide, etc.). While the choice of photoacid progenitor is not critical, it is desirable that said photoacid progenitor have limited solubility in water in order to provide maximal inkability.

In a preferred embodiment, the photoacid progenitor is a substituted or unsubstituted diaryliodonium salt as described in U.S. Patent Nos. 3,729,313, 4,076,705, and 4,386,154.

Non-limiting examples of suitable iodonium salts are salts of diphenyliodonium, dinaphthyliodonium, di(4-chlorophenyl)iodonium, tolyl(dodecylphenyl)iodonium, naphthylphenyliodonium salts, 4-(trifluoromethylphenyl)phenyliodonium, 4-ethylphenylphenyliodonium, di(4-acetylphenyl)iodonium, tolylphenyliodonium, anisylphenyliodonium, 4-butoxyphenylphenyliodonium, di(4-phenylphenyl)iodonium, di(carbomethoxyphenyl)iodonium, etc., with anions including complex halogenated metal anions such as hexafluorophosphate, hexafluoroantimonate, hexafluoroarsenate; borates such as tetrafluoroborate and tetraphenylborate. Particularly preferred anions are hexafluorophosphate, hexafluoroantimonate, hexafluoroarsenate, and tetrafluoroborate. Diphenyliodonium complex halogenated metal anion salts are preferred.

Other photoacid progenitors useful in practice of the present invention include photolyzable organic halogen compounds that are useful in the present invention are those that upon exposure to radiation dissociate at one or more carbon-halogen bonds to form free radicals. The carbon-halogen bond dissociation energy should be between about 40 and 70 kcal/mole as taught in U.S. Patent Nos. 3,515,552. Preferred photolyzable organic halogen compounds have from 1 to 40 carbon atoms, are non-gaseous at room temperature, and have a polarographic half-wave reduction potential greater than about -0.9 V as described in U.S. Patent Nos. 3,640,718 and 3,617,288.

Examples of photolyzable organic halogen compounds are hexabromoethane, α,α,α,α-tetrabromoxylene, carbon tetrabromide, *m*-nitro(tribromoacetyl)benzene, α,α,α-trichloroacetanilide, trichloromethylsulfonylbenzene, tribromoquinaldine, bis(pentachlorocyclopentadiene), tribromomethylquinoxaline, α,α-dibromo-*p*-nitrotoluene, α,α,α,α,α,α-hexachloro-*p*-xylene, dibromotetrachloroethane, pentabromoethane, dibromodibenzoylmethane, carbon tetraiodide, halomethyl-*s*-triazines such as 2,4-bis(trichloromethyl)-6-methyl-*s*-triazine, 2,4,6-tris(trichloromethyl)-*s*-triazine, and 2,4-bis(trichloromethyl)-6-(*p*-methoxystyryl)-*s*-triazine, etc.

The photoacid progenitor employed in the present invention may be either exposed to ultraviolet radiation or sensitized into the visible spectrum. Wavelengths between 250 nm and 900 nm inclusive may be used. Compounds useful as sensitizing dyes of this invention include, but are not limited to aryl nitrones, xanthenes, anthraquinones, substituted diaryl- and triarylmethanes, methines and polymethines, stilbenes, thiazoles, substituted and unsubstituted polycyclic aromatic hydrocarbons (e.g., anthracenes), 1,3-diaryl-1-pyrazoline, isobenzofuran, polyarylenes, coumarin, and pyrylium dyes. It is preferred that the sensitizer, if used, not have basic groups attached thereto as this tends to reduce the effectiveness of the photogenerated acid.

In some instances it is desirable to add at least one additional polymer to the light-sensitive photopolymer layers of the present invention. Said additional polymer may be present in amounts up to 90 percent by weight, preferably not more than 50 percent, and most preferably not more than 30 percent. In one embodiment, said additional polymer is a homo- or copolymer of an acid anhydride such as a homo- or co-polymer of maleic anhydride (e.g., Gantrez AN-139, Gantrez is registered trademark of GAF Corp., Wayne, NJ).

Additionally, it may be desirable to treat the light-sensitive photopolymer layers of the present invention with at least one hydrophilizing agent subsequent to exposure. Suitable hydrophilizing agents increase the wettability in exposed regions without affecting the wettability in unexposed regions of the photosensitive composition, thereby increasing the differential in wettability between exposed and unexposed regions. Preferably, said at least one hydrophilizing agent is a nitrogen-containing compound. Most preferably, said nitrogen-containing compound is an 1°, 2°, 3°, or 4° amine-substituted sulfonic acid or its salt having from 2 to 18 carbon atoms (e.g., 4-morpholinepropanesulfonic acid, β-hydroxy-4-morpholinepropanesulfonic acid salt, 4-morpholineethanesulfonic acid, sodium 4-morpholinepropanesulfonate, sodium cysteate, pyridinium, etc.), an 1°, 2°, 3°, or 4° amine-substituted alcohol (e.g., tetrakis(2-hydroxyethyl)ethylenediamine, 2-amino-1,3-propanediol, triethanolamine, etc.) or amine-substituted carboxylic acid (e.g., glycine, alanine, 3-dimethylaminopropanoic acid, etc.) The method of treatment is not critical and may be accomplished for example by wiping or spraying the hydrophilizing agent onto the exposed plate, or by dipping the exposed plate into a solution of the hydrophilizing agent, or by means of a fountain solution when used on a press.

Coating of the light-sensitive photopolymer layers may be achieved by many methods well known in the imaging art (e.g., solvent casting, knife coating, extrusion, cascading, curtain coating, etc.). The various layers of the present invention may contain various materials in combination with the essential ingredients of the present invention. For example, plasticizers, coating aids, antioxidants, surfactants, antistatic agents, waxes, ultraviolet radiation absorbers, and brighteners may be used without adversely affecting the practice of the invention. Said various materials employed in the light-sensitive photopolymer layer must not contain functional groups that are more basic than the alkoxyalkyl ester employed in the present invention (i.e., free amines, alkoxides, sulfides, amides, urethanes, imides, etc.) as defined above, in a molar amount higher than the molar amount of photoacid precursor.

In a preferred embodiment of the present invention the dry silver mask may be a thermographic layer (i.e., a thermal recording layer wherein the light sensitive silver halide is omitted). Thus, thermal recording layers useful in practice of the present invention comprise: (a) a thermally reducible source of silver; (b) reducing agent for silver ion; (c) a polymeric binder; and (d) an optional near-infrared absorbing dye.

Any reducing agent for silver ion can be used in the present invention. Such reducing agents are well-known to those skilled in the art. Examples of such reducing agents include, but are not limited to, methyl gallate, hindered phenols, catechol; pyrogallol; hydrequinones; substituted hydroquinones; ascorbic acid; ascorbic acid derivatives; leuco dyes; and the like. Preferably, the reducing agent comprises a 3-indazolinone or urea compound as a development accelerator.

Such 3-indazolinone compounds and urea compounds can be synthesized according to procedures well known to those skilled in the art of synthetic organic chemistry. Alternatively, such materials are commercially available, such as from Aldrich Chemical Company of Milwaukee, Wisconsin; Lancaster Chemical Company of Windham, New Hampshire; and K & K Laboratories of Cleveland, Ohio.

3-Indazolinone compounds that can be used in the present invention have the following structure: 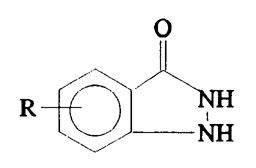
wherein: **R** is selected from the group consisting of: hydrogen; an alkyl group of 1 to 4 carbon atoms; halogen; -COOH and -**R¹**COOH wherein **R¹** is an alkyl group having from 1 to 4 carbon atoms. Preferably, **R** is hydrogen or an alkyl group having from 1 to 4 carbon atoms and most preferably, **R** is hydrogen.

Urea compounds which can be used in the present invention have the formula: 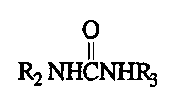
wherein **R²** and **R³** each independently represent hydrogen; a C₁-C₁₀ alkyl or cycloalkyl group; or phenyl; or **R²** and **R³** together form a heterocyclic group containing up to 6 ring atoms. Preferably **R²** and **R³** represent hydrogen; a C₁ to C₅ alkyl or cycloalkyl group; or phenyl; or **R²** and **R³** together form a heterocyclic group containing up to 5 ring atoms. Preferably, the reducing agent comprises a 3-indazolinone or a urea compound is urea or an alkyl or aryl substituted urea such as *N*-butylurea, *N,N*'-diethylurea, 2-imidazolidone, or *N,N*'-diphenylurea.

Whatever reducing agent is employed in the present invention is preferably used in an amount of about 0.01 weight percent to 15 weight percent, based upon the total weight of the imaging system layers.

The term "near-infrared", as used herein, refers to the wavelength region between about 700 nm and 1100 nm.

A further advantage of this invention is that thermographic materials (e.g., films or papers) can be imaged electronically using a simple laser scanner that requires no post-thermal processing step for the media. Laser scanning technology gives higher resolution than a thermal stylus printhead, leading to this media's utility for high resolution applications such as graphic arts and diagnostic imaging.

The thermal recording layer comprises a thermally reducible source of silver. The latter are materials, which in the presence of a reducing agent, undergo reduction at elevated temperatures, e.g., 60°-225°C. Preferably, these materials are silver salts of long chain alkanoic acids (also known as long chain aliphatic carboxylic acids or fatty acids) containing 10 to 30 carbon atoms and more preferably, 10 to 28 carbon atoms. The latter are also known in the art as "silver soaps." Non-limiting examples of silver salts of aliphatic carboxylic acids include silver behenate, silver stearate, silver oleate, silver laurate, silver caproate, silver myristate, silver palmitate, silver maleate, silver fumarate, silver tartarate, silver linoleate, silver butyrate, silver camphorate, and mixtures thereof. Complexes of organic or inorganic silver salts wherein the ligand has a gross stability constant between 4.0-10.0 can also be used. Silver salts of aromatic carboxylic acids and other carboxyl group-containing compounds include silver benzoate, a silver-substituted benzoate such as silver 3,5-dihydroxybenzoate, silver *o*-methylbenzoate, silver *m*-methylbenzoate, silver *p*-methylbenzoate, silver 2,4-dichlorobenzoate, silver acetamidobenzoate, silver *p*-phenyl benzoate, etc., silver gallate, silver tannate, silver phthalate, silver terephthalate, silver salicylate, silver phenylacetate, silver pyromellitate, silver salts of 3-carboxymethyl-4-methyl-4-thiazoline-2-thiones or the like as described in U.S. Patent No. 3,785,830; and silver salts of aliphatic carboxylic acids containing a thioether group as disclosed in U.S. Patent No. 3,330,663. Silver salts of compounds containing mercapto or thione groups and derivatives thereof can also be used. Preferred examples of these compounds include silver 3-mercapto-4-phenyl-1,2,4-triazolate, silver 2-mercaptobenzimidazolate, silver 2-mercapto-5-aminothiadiazolate, silver 2-(*S*-ethylglycolamido)benzothiazolate; silver salts of thioglycolic acids such as silver salts of *S*-alkyl thioglycolic acids (wherein the alkyl group has from 12 to 22 carbon atoms); silver salts of dithiocarboxylic acids such as silver dithioacetate, silver thioamidoate, silver 1-methyl-2-phenyl-4-thiopyridine-5-carboxylate, silver triazinethiolate, silver 2-sulfidobenzoxazole; and silver salts as disclosed in U.S. Patent No. 4,123,274. Furthermore, silver salts of a compound containing an amino group can be used. Preferred examples of these compounds include silver salts of benzotriazoles, such as silver benzotriazolate; silver salts of alkyl-substituted benzotriazoles such as silver methylbenzotriazolate, etc.; silver salts of halogen-substituted benzotriazoles such as silver 5-chlorobenzotriazolate, etc.; silver salts of carboimidobenzotriazoles, etc.; silver salts of 1,2,4-triazoles and 1-*H*-tetrazoles as described in U.S. Patent No. 4,220,709; silver salts of imidazoles; and the like. Preferably, the silver source material should constitute from about 5-50 percent by weight of the image forming system and more preferably, from about 10-30 percent by weight.

Optionally, if infrared laser addressability is desired, the thermal recording layer may contain an infrared dye which absorbs near-infrared light having a wavelength in the range of between about 700 - 1100 nm. If a red-emitting laser diode is used, the recording laser may contain a dye that absorbs at these red wavelengths, e.g. 630 or 670 nm. If a frequency-doubled Nd-YAG or ND-YLF laser is used, then the recording layer may contain a dye that absorbs in the range between about 520-540 nm. Suitable dyes include, but are not limited to, oxonol, squarylium, chalcogenopyrylarylidene, bis(chalcogenopyrylo)polymethine, bis(aminoaryl)polymethine, merocyanine, trinuclear cyanine, indene-bridged polymethine, oxyindolizine, ferrous complex, quinoid, nickel dithiolene complex, and cyanine dyes such as carbocyanine, azacarbocyanine, hemicyanine, styryl, diazacarbocyanine, triazacarbocyanine, diazahemicyanine, polymethinecyanine, azapolymethinecyanine, holopolar, indocyanine, squarylium, and diazahemicyanine dyes. Since the role of the near-infrared dyes is simply to convert near-infrared electromagnetic radiation to heat, any near-infrared absorbing dye known in the art may be used.

Preferably, the infrared absorbing dyes should be present in an amount of from about 0.001-10 weight percent and more preferably, in an amount of from about 0.005-5 weight percent, based upon the total weight of the imaging system employed in the present invention.

The thermal recording layer may be imaged by contact with thermal energy such as by a thermal print head or exposure to near-infrared radiation, either from a heat lamp through a mask or preferably from a near-infrared laser diode, and more preferably from a Nd-YAG laser. If an infrared radiation source is employed then an infrared dye should be employed to convert the infrared energy to heat. As is well known in the thermal imaging art, near-infrared laser diodes may be advantageously arranged in an array to increase imaging speed. Lasers that can be used to provide near-infrared radiation include substantially any laser capable of generating light in the near-infrared region of the electromagnetic spectrum, including dye lasers; gas lasers such as krypton-ion lasers; solid state diode lasers such as gallium arsenide diode lasers that emit in the region of 750 to 870 nm and diode array pumped Nd-YAG lasers at 1065 nm. Preferably, the laser radiation comes from a solid state diode laser arranged in an array and more preferably from a diode array pumped Nd-YAG laser.

The thermal recording layers of the present invention are not light-sensitive in the traditional sense and therefore, do not contain photosensitive agents such as silver halides; photoinitiator; or photogenerated bleaching agents. The imaging elements can have less than 1 to 2% by weight (substantially no effective amount of) these materials and perform well. They may be totally free of these materials in the imaging element.

The use of conventional toners such as phthalazinone, phthalazine, and phthalimide can also be used in the image forming layer, if desired. When utilized, the toner should preferably be present in the image forming layer in an amount in the range of 1-6 weight percent and more preferably, 2-5 weight percent, based upon the total weight of the imaging layer.

Optionally, an anti-stick layer, positioned on top of the image forming layer, may be used. Any conventional anti-stick material may be employed in the present invention. Examples of such anti-stick materials, include, but are not limited to waxes, silica particles, styrene-containing elastomeric block copolymers such as styrene-butadiene-styrene, styrene-isoprene-styrene, and blends thereof with such materials as cellulose acetate, cellulose acetate butyrate, and cellulose acetate propionate.

Further, an anti-static or anti-stick layer may optionally be applied to the back of the support. Materials for such purpose are well known in the photothermographic imaging art.

The imaging, anti-stick, and anti-static layers employed in the present invention can be applied by any method known to those skilled in the art such as knife coating, roll coating, dip coating, curtain coating, hopper coating, etc.

Where the term group is used in describing substituents, substitution is anticipated on the substituent for example, alkyl group includes ether groups (e.g., CH₃-CH₂-CH₂-O-CH₂-), haloalkyls, nitroalkyls, carboxyalkyls, hydroxyalkyls, etc., while the term alkyl includes only hydrocarbons. Substituents that react with active ingredients, such as very strong reducing or oxidizing substituents would, of course, be excluded as not being sensitometrically inert or harmless.

### EXAMPLES

Materials used in the following examples were available from standard commercial sources such as Aldrich Chemical Co. (Milwaukee, WI) unless otherwise specified.

Dye A has the structure: 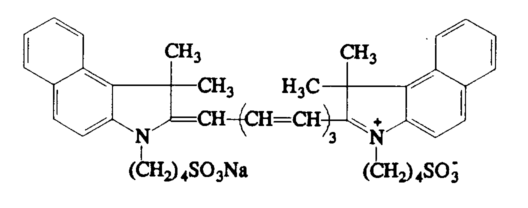
Dye B has the structure: 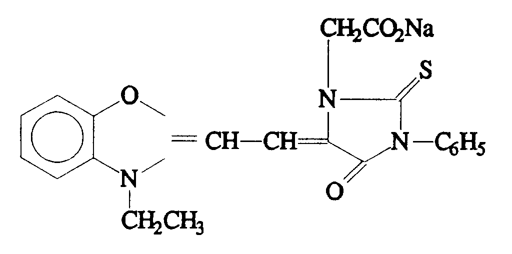
Dye C has the structure: 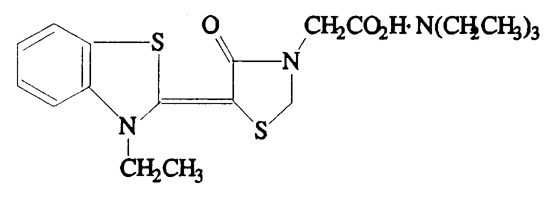
Antioxidant A has the structure

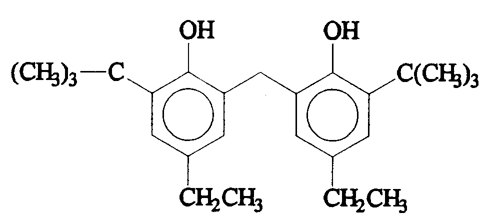

### EXAMPLE 1

This example describes a high speed, dry-processed lithographic printing plate construction.

A poly(tetrahydropyranyl methacrylate) mixture was prepared by mixing the following ingredients: 1.5 ml of a 10 wt% solution of Gantrez AN-139™ (GAF Corp., a copolymer of methyl vinyl and maleic anhydride) in methyl ethyl ketone, 0.5 ml of a 33 wt% solution of poly(tetrahydropyranyl) methacrylate in methyl ethyl ketone, 0.078 g diphenyliodonium hexafluorophosphate, 0.020 g 9,10-diethoxyanthracene, and 4.4 ml methyl ethyl ketone. This mixture was coated onto brush grained, electrochemically grained, and anodized aluminum sheeting using a #12 wire-wound bar (R&D Specialties, Webster, NY) and dried in an oven at 85°C for 5 minutes.

The poly(tetrahydropyranyl methacrylate) containing layer was overcoated with a 5% by weight polyvinyl alcohol solution in water with a #12 wire-wound bar and dried at 70°C for 10 minutes.

A dry silver emulsion was prepared by mixing: 139.2 g silver behenate soap homogenate (300 g silver behenate, 525 g toluene, 1675 g methyl ethyl ketone, and 13.5 g Butvar B76™), 0.13 g mercuric bromide, 0.26 g zinc bromide, 21.1 g Butvar B76™, 0.75 g pyridine, 2.2 g FC-431™ (a fluorochemical surfactant from 3M), 37.9 g methyl ethyl ketone, 3.1 g methanol.

A top coat solution containing the following chemicals was prepared by mixing: 1.66 g Acryloid A-21™, 0.62 g 4-methylphthalic acid, 0.19 g tetrachlorophthalic acid, 0.41 g tetrachlorophthalic anhydride, 0.88 g phthalazine, 0.04 g FC-431™ (Fluorochemical surfactant from 3M), 6.89 g CAE 398-6™ (Cellulose acetate ester from Eastman Kodak), 12.64 g acetone, 72.0 g methyl ethyl ketone, 4.72 g methanol.

Twenty grams of the dry silver emulsion was mixed with 0.435 g of Antioxidant A, 0.098 g of 0.17 wt% Dye C blue sensitizing dye in methanol, and 0.098 g of 0.17 wt% Dye B green sensitizing dye in methanol. The resulting sensitized emulsion was then knife-coated on the polyvinyl alcohol-topcoated plate at a 0.076 mm gap. After drying in room air, it was overcoated with the above topcoat solution in the same manner at a 0.076 mm gap and air dried.

The dried plate was exposed for 0.1 msec in an EG&G sensitometer with a test print chart (Dₘₐₓ = 1.1) as a mask, then heat-developed at 138°C for 10 seconds. The plate was then exposed through the black silver image to UV in a 2 kW Berkey Ascor exposure from equipped with an Addalux diazo bulb for 30 sec. Then the polyvinyl alcohol, silver emulsion, and topcoat layers were peeled off, leaving behind the imagewise-exposed poly(tetrahydropyranyl methacrylate) layer. The plate was then immersed in a solution consisting of 10 g sodium bicarbonate, 10 g 4-morpholineethanesulfonic acid monohydrate and 100 ml water. The plate was then hand inked with a black printer's ink. The unexposed areas of the plate accepted ink very well, while the UV-exposed repelled ink to give a clean, ink-free background.

### EXAMPLE 2

This example describes a high speed, dry-processed lithographic printing plate construction.

Commercially available 3M "8500" COM film was used as the dry silver portion of the integral printing plate construction. This film consists of 0.10 mm polyester base, a red sensitive dry silver layer and a VYNS™ topcoat (10:90 vinyl acetate, vinyl chloride copolymer from Union Carbide). A polyvinyl alcohol solution (5% Gelvatol 9000™ from Monsanto in water containing 0.1% Triton X-100™ surfactant) was knife coated at 0.076 mm over the VYNS layer of the 8500 COM film and dried for 3 minutes at 88°C. A solution consisting of 33 wt% poly(tetrahydropyranyl methacrylate), 0.5 wt% 2-ethyl-9,10-dimethoxyanthracene, and 2 wt% diphenyliodonium hexafluorophosphate in methyl ethyl ketone was coated at 0.064 mm over the polyvinyl alcohol layer and dried for 3 minutes at 88°C. A clear black and white original film image was contacted to the top of this film in a vacuum frame and the dry silver layer was exposed with a tungsten lamp for 0.4 seconds. A black dry silver image was obtained by developing the exposed film for 12 seconds in a 3M FC-43 Fluorinert™ bath set at 127°C. The poly(tetrahydropyranyl methacrylate) layer was then flood exposed through the back of the film for 60 seconds using a 500 watt medium pressure mercury lamp. The integral dry silver black image served as the mask during the exposure. The exposed poly(tetrahydropyranyl methacrylate) layer was then wiped with a cloth soaked with 2.5 wt% 4-morpholineethanesulfonic acid monohydrate and 2.6 wt% sodium bicarbonate in water and the plate inked under water with Northern Web Offset Black ink No. 10-2032. The plate accepted ink only in those areas not exposed during the flood exposure step. This was demonstrated by transferring ink imagewise from the plate to paper under pressure.

### EXAMPLE 3

This example describes a high speed, dry-processed lithographic printing plate construction.

A dispersion consisting of 3.0 wt% Nalco 2326 colloidal silica, 0.3 wt% aminopropyltrimethoxysilane, and 0.03 wt% Triton X-100™ surfactant (Rohm & Haas Co.) was coated with a #4 wire-wound bar onto the back side of 3M 8500 COM film (i.e. a dry silver film) and dried for 2 minutes at 100°C. A solution consisting of 0.04 g diphenyliodonium hexafluorophosphate, 0.01 rubrene, 0.75 g 33 wt% poly(tetrahydropyranyl methacrylate), and 1.5 g methyl ethyl ketone was coated on top of the colloidal silica layer using a #6 wire-wound bar and dried 2 minutes at 80°C. The resulting film was exposed through a black-on-clear original onto the dry silver layer for 1 second using a 3M Model 179 tungsten light source. The film was developed at 127°C for 7 seconds in a 3M FC-43 Fluorinert™ bath, giving a black dry silver image. The film was then exposed for 45 sec through the dry silver image onto the backside poly(tetrahydropyranyl methacrylate) layer using a 3M Model 70 tungsten light source. The poly(tetrahydropyranyl methacrylate) layer was then wiped with a cloth soaked with a solution consisting of 2.6 wt% sodium bicarbonate and 2.5 wt% 4-morpholineethanesulfonic acid monohydrate. The film was then inked under water using a pad coated with a black lithographic ink. Only those areas of the poly(tetrahydropyranyl methacrylate) layer unexposed to light, corresponding to the Dₘₐₓ (exposed) areas of the dry silver layer, were successfully inked. The inked image was transferred to paper under pressure.

### EXAMPLE 4

The following example illustrates the use of thermographic dry silver as an integral mask for a printing plate construction. A near infrared dye absorber either in an underlayer to the dry silver emulsion or in the dry silver emulsion itself serves as a light-to-heat conversion element of near infrared light from a laser source to trigger the thermographic development of the dry silver to form an image. This image is then used as a mask to expose the underlying photopolymer layer with wavelengths of light at which the photopolymer layer is sensitized, typically the UV region of the spectrum.

Coating Solutions were prepared as given below:

| Coating Solution A: | |
|---|---|
| 10:1 copolymer of tetrahydropyranyl methacrylate and 3-methacryloxypropyltrimethoxysilane (poly(THP/MATS)) | 0.34 g |
| 9,10-Diethoxyanthracene | 0.04 g |
| diphenyliodonium hexafluorophosphate | 0.04 g |
| Methyl ethyl ketone (MEK) | 1.66 g |
| 5% Isocyanatopropyltriethoxysilane in MEK (w/w) | 0.2 g |
| 5% Dibutyltindilaurate in MEK (w/w) | 0.1 g |
| Ethyl violet | 0.003g |

| Coating Solution B: | |
|---|---|
| 5% Airvol 540 (PVA from Air Products) in water/methanol (2.3:1 w/w) | 12 g |
| Dye A (IR-125,Kodak) | 0.025 g |

| Coating Solution C: | |
|---|---|
| Full soap dispersion consisting of 12% Ag Behenate and 0.54% Butvar B-76™ in 1:3 toluene/MEK | 13.33 g |
| Butvar B-76™ (Monsanto) | 1.67 g |
| Methyl gallate | 0.6 g |
| L-Ascorbic acid palmitate | 0.05 g |
| Succinimide | 0.2 g |
| 2-Imidazolidone | 0.1 g |
| Tetrachlorophthalic anhydride | 0.05 g |
| Methanol | 1 ml |
| Methyl ethyl ketone | 1 ml |

Coating Solution A was coated with a #6 wire-wound bar onto .004" polyester film primed with about 0.04 microns of a poly(vinylidene chloride) containing terpolymer and overcoated with a layer of Nalco 2326 colloidal silica and aminopropyltrimethoxysilane according to European Patent Application 301,827 A2 and dried 2 minutes at 90°C. The dried coating was then coated with Coating Solution B using a #22 wire-wound bar and dried 2 minutes at 90°C. Coating Solution C was then applied as a topcoat using a knife coater set at a gap of .004" and dried 3 minutes at 50°C.

A sample of this coating was first exposed through the Dry Silver layer with a 200 mW laser diode array emitting at 820 nm focused onto an x-y table to generate the dry silver image as black stripes. These black stripes were then used as a mask for exposure through the Dry Silver layer for 20 seconds in a Berkey Ascor exposure frame quipped with a 2 kW photopolymer bulb. After UV exposure the Dry Silver and polyvinyl alcohol (PVA) layers were peeled off after laminating with Scotch™ Magic™ Tape 810 (3M) adhesive tape. The ethyl violet in the photopolymer layer bleached in the exposed areas, leaving a blue print-out image that was clearly visible after the peeloff step. This image layer was then rubbed with a cotton pad soaked with a solution consisting of 2.5% sodium bicarbonate and 2.5% 4-morpholineethanesulfonic acid. The exposed, treated film was then inked under water using black Rub Up Ink U-620™ (Printing Developments, Inc.). Ink was repelled in the exposed regions of the coating whereas the unexposed regions of the coating protected from UV light by the Dry Silver mask readily accepted ink.

## Claims

1. A lithographic printing plate comprising a substrate, a photothermographic silver halide imaging layer, and a photosensitive photopolymer layer in which the polymer comprises an acid labile ester component and a photoacid progenitor, with the proviso that when said photopolymer layer is between said substrate and said photothermographic layer, the photothermographic layer is strippable from said photopolymer layer.

2. The printing plate of claim 1 comprising layers in an order of a) said photopolymer layer, a transparent substrate, and said photothermographic layer, or b) a substrate, said photothermographic layer, and said photopolymer layer.

3. The plate of claim 1 wherein an interlayer is between said photopolymer layer and said photothermographic layer.

4. The plate of claim 1 comprising layers in an order of a substrate, said photopolymer layer, a strippable layer, and said photothermographic layer, and wherein there is a barrier layer over said photothermographic layer.

5. The plate of claim 1 wherein said polymer has pendant groups of the formula: 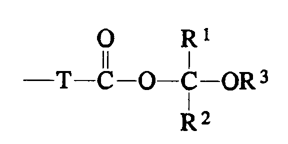 wherein **R¹** and **R²** independently represent hydrogen or an alkyl group having from 1 to 18 carbon atoms and, **R³** represents an alkyl group having from 1 to 18 carbon atoms or any two of **R¹**, **R²**, and **R³** may together form a ring group, and
**T** is a bond or a divalent linking group of no more than a total of 18 non-hydrogen atoms selected from carbon, nitrogen, oxygen or sulfur atoms.

6. The plate of claim 8 wherein said polymer comprises a non-basic polymer backbone selected from the group consisting of polyacrylates, polymethacrylates, polystyrenes, acrylonitrile-styrene, copolymers, butadiene-styrene copolymers, butadiene-styrene-acrylonitrile copolymers, polyolefins, polyesters, polyethers, polycarbonates, and polysulfides.

7. The plate of claims 1, 5 or 6 wherein said photothermographic layer comprises a binder, silver halide, a light-insensitive silver salt, and a reducing agent for silver ion.

8. A lithographic printing plate comprising a substrate, a thermographic silver imaging layer, and a photosensitive photopolymer layer in which the polymer comprises an acid labile ester component and a photoacid progenitor, with the proviso that when said photopolymer layer is between said substrate and said thermographic layer, the thermographic layer is strippable from said photopolymer layer.

9. The printing plate of claim 8 comprising layers in an order of said photopolymer layer, a transparent substrate, and said thermographic layer.

10. The plate of claim 8 wherein said polymer has pendant groups of the formula: 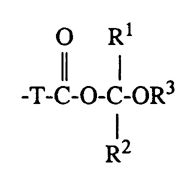 wherein **R¹** and **R²** independently represent hydrogen or an alkyl group having from 1 to 18 carbon atoms and, **R³** represents an alkyl group having from 1 to 18 carbon atoms or any two of **R¹**, **R²**, and **R³** may together form a ring group, and
**T** is a bond or a divalent linking group of no more than a total of 18 non-hydrogen atoms selected from carbon, nitrogen, oxygen or sulfur atoms.
